**Europäisches Patentamt**

**European Patent Office**

**Office européen des brevets**

(11) Veröffentlichungsnummer: **0 460 254 A1**

# (12) EUROPÄISCHE PATENTANMELDUNG

(21) Anmeldenummer: 90110659.1

(22) Anmeldetag: 06.06.90

(51) Int. Cl.5: **C23C 16/40**

(43) Veröffentlichungstag der Anmeldung:
**11.12.91 Patentblatt 91/50**

(84) Benannte Vertragsstaaten:
**BE CH DE DK ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**W-1000 Berlin 65(DE)**

(72) Erfinder: **Bald, Jochen**
**Fichtenweg 24**
**W-7400 Tübingen(DE)**
Erfinder: **Deutschmann, Lutz**
**Hauptstrasse 99**
**W-7415 Wannweil(DE)**
Erfinder: **Feurer, Ernst, Dr.**
**Im Riedle 10**
**W-7906 Blaustein / Markbronn(DE)**
Erfinder: **Holzschuh, Helga**
**Schlehenweg 6**
**W-7414 Lichtenstein(DE)**
Erfinder: **Oehr, Christian, Dr.**

**Wintergasse 6**
**W-7403 Reusten(DE)**
Erfinder: **Messelhäuser, Johannes, Dr.**
**Gmelinstrasse 68**
**W-7400 Tübingen(DE)**
Erfinder: **Ramirez, Javier**
**Fichtenweg 17**
**W-7400 Tübingen 1(DE)**
Erfinder: **Reich, Silvia**
**Hausserstrasse 142**
**W-7400 Tübingen 1(DE)**
Erfinder: **Waimer, Birgit (Mitulidis)**
**Bahnhofstrasse 41**
**W-4047 Dormagen(DE)**
Erfinder: **Weber, Andreas**
**Öschweg 15**
**W-7430 Metzingen(DE)**
Erfinder: **Wendel, Helmut**
**Landhausstrasse 3**
**W-7400 Tübingen(DE)**
Erfinder: **Suhr, Harald, Prof. Dr. rer. nat.**
**Weissdornweg 2**
**W-7400 Tübingen(DE)**

(54) **Verfahren zur Herstellung dünner Oxydschichten durch die Plasma-Umsetzung metallorganischer Verbindungen.**

(57) Die Erfindung betrifft ein Verfahren zur Herstellung dünner Oxydschichten durch die Plasmaumsetzung metallorganischer Verbindungen, dadurch gekennzeichnet, daß flüchtige Metallverbindungen oder Mischungen aus Metallverbindungen verwendet werden.

EP 0 460 254 A1

Die Erfindung betrifft ein Verfahren zur Herstellung dünner Oxydschichten durch die Plasmaumsetzung metallorganischer Verbindungen.

Die Herstellung von Oxydschichten oder -filmen ist an sich bekannt.

So kann man Oxydschichten durch Sputtern erzeugen. Aber Oxyde sputtern relativ schlecht. Oft weisen die Produkte Sauerstoffdefizite auf und müssen nachoxydiert werden.

Weiterhin kann man Oxydschichten durch reaktives Sputtern erzeugen. Dies vermeidet die Notwendigkeit der Nachoxydation. Oft sind die Abscheideraten gering. Ferner ist der apparative Aufwand (sehr gutes Vakuum erforderlich) beträchtlich. Bei allen Sputterverfahren tritt Schattenbildung auf, das heißt dreidimensionale Obkekte werden nicht gleichmäßig beschichtet.

Es ist auch möglich, Oxydschichten in Einzelfallen durch galvanische Verfahren oder auf Metallen durch Oxydation bei höheren Temperaturen zu erzeugen.

Schließlich können Oxydschichten durch thermisches- oder Laser- CVD Verfahren abgeschieden werden.

Aufgabe der vorliegenden Erfindung ist die Zurverfügungstellung eines Verfahrens, welches in technisch einfacher Weise für eine Vielzahl von Beschichtungen anwendbar ist, welches Metall für Beschichtungen zugänglich macht, von denen es keine flüchtigen Hydride oder Halogenide gibt und das hierdurch eine erhöhte Anwendungsbreite besitzt und welches die Herstellung von Oxydschichten erlaubt, die ganz oder weitgehend frei von Verunreinigungen sind.

Diese Aufgabe wird erfindungsgemäß durch ein Verfahren gemäß dem kennzeichnenden Teil des Patentanpruchs gelöst.

Weitere Ausgestaltungen der Erindung sind den Kennzeichnungsteilen der Unteransprüche zu entnehmen.

Das erfindungsgemäße Verfahren vermeidet nicht nur die Nachteile der bekannten Verfahren, sondern es schafft darüberhinaus völlig neue technische Perspektiven, die sich wie folgt darstellen.

Das Verfahren ist einfach und für eine Vielzahl von Beschichtungen anwendbar. Je nach geüwnschtem Oxyd muß eine geeignete metallhaltige Verbindung eingesetzt werden. Die experimentellen Parameter unterscheiden sich für die meisten Probleme nur wenig voneinander.

Durch die Verwendung von metallhaltigen Ausgangsverbindungen werden auch Metalle für die Beschichtungen zugänglich, von denen es keine flüchtigen Hydride oder Halogenide gibt. Dadurch wird die Anwendungsbreite wesentlich vergrößert.

Durch den Zusatz von Oxydationsmitteln werden Verunreinigungen aus den Filmen ganz oder weitgehend entfernt.

Durch die Verwendung von elektrischen Entladungen (Plasmen) kann die Zersetzungstemperatur gegenüber dem thermischen CVD erheblich herabgesetzt werden. Erfahrungen aus zahlreichen Systemen zeigen, daß Plasmaverfahren schon bei um 500° tieferen Temperaturen als die thermischen Verfahren zur Beschichtung eingesetzt werden können. Dadurch können die Verfahren auch bei temperaturempfindlichen Materialien, wie organischen Polymeren eingesetzt werden.

Durch die Verwendung von Plasmen treten keine Probleme mit der Schattenbildung auf. Es können dreidimensionale Objekte und auch Hohlräume (Löcher) beschichtet werden.

Durch die Verwendung von Plasmen ist die wachsende Schicht einem ständigen Bombardement von Ionen, Elektronen und Photonen ausgesetzt. Diese bewirken die Entfernung von Verunreinigungen und erhöhen die Oberflächenbeweglichkeit der auftreffenden Teilchen.

Durch die Verwendung von Plasmen werden die zu beschichtenden Substrate von Verunreinigungen und anhaftender Feuchtigkeit gereinigt. Dadurch werden wesentlich bessere Haftfestigkeiten erzielt als bei anderen Verfahren.

Durch die Verwendung von Zusatzpotentialen an den Elektroden kann das Ionenbombardement der wachsenden Schicht gesteuert werden.

Durch die Temperierung der Elektrode, die die Substrate trägt oder der Substrathalter kann die Abscheidegeschwindigkeit und das Ausmaß der zulässigen Verunreinigungen gesteuert werden.

Zur Durchführung des erfindungsgemäßen Verfahrens kommen als Ausgangsmaterialien alle flüchtigen metallhaltigen beziehungsweise metallorganischen Verbindungen in Frage, vor allem solche, die bei Raumtemperatur einen Dampfdruck von $\geq 1$ Pa besitzen sowie all diejenigen Verbindungen, die man ohne Zersetzung auf Temperaturen bringen kann, bei denen diese Drucke erreicht werden, und ferner diejenigen, die solche Temperaturbehandlung zumindest ohne übermäßige Zersetzung überstehen.

Folgende Ausgangsverbindungen sind zu nennen:
Substanzen können eingesetzt werden, bei denen direkte Metall-Kohlenstoff Bindungen wie zum Beispiel bei den Metallalkylen
$Sn(CH_3)_4$, $SN(C_2H_5)_4$ oder $Sn(C_3H_7)_4$, sowie solchen mit gemischten Alkylen $SnR'R''R'''R''''$, wie $GeR_4$,

PbR$_4$, ZnR$_2$, CdR$_2$, InR$_3$, AsR$_3$ oder BiR$_3$.
- gebundene Komplexe wie Verbindungen mit Allyl-, Cyclopentadienyl-, Alkylcyclopentadienyl-, Cyclooctadienyl- oder Aromatenkomplexe wie zum Beispiel Pd(C$_3$H$_6$)$_2$, Pd(C$_5$H$_5$)$_2$, (C$_5$H$_5$)Pd(C$_3$H$_6$), Pd-(RnC$_5$H$_{5-n}$)$_2$ oder

(C$_5$H$_5$)Pd(R$_n$C$_{5-n}$) oder
entsprechende Verbindungen andrere Metalle zum Beispiel des Eisens, Cobalts oder Nickels wie Fe(C$_5$H$_5$)$_2$, Co(C$_5$H$_5$)$_2$, Ni(C$_5$H$_5$)$_2$ oder solche mit anderen Liganden wie Fe(R$_n$C$_5$H$_{5-n}$)$_2$ .
Metallcarbonyle wie
Cr(CO)$_6$, Mo(CO)$_6$, W(CO)$_6$, Mn$_2$(CO)$_{10}$, Re$_2$(CO)$_{10}$, Fe(CO)$_5$, Ru(CO)$_5$, Os$_2$(CO)$_9$, Co$_2$(CO)$_8$, Rh$_2$(CO)$_8$, Ir$_2$(CO)$_8$, Ni(CO)$_4$, und deren Derivate wie die
Metall-carbonyl-nitrosyle (M(NO)$_x$(CO)$_y$
Metall-carbonyl-hydride MH$_x$(CO)$_y$
Metall-carbonyl-halide MHal$_x$(CO)$_y$
zum Beispiel Co(CO)$_3$(NO), FE(CO)$_2$(NO)$_2$ und mehrkernige Carbonyle
Diketonatokomplexe wie die Acetylacetonate und deren durch Substitution durch Fluor oder Alkylgruppen gewonnenen Abkömmlinge. Typische Chelatbildner sind 2,4-Pentandion ("acac"),
1,1,1 Trifluor-2,4-pentandion ("tfa"),
1,1,1,5,5,5-Hexafluor-2,4-pentandion ("hfa")
2,26,6-Tetramethyl-heptandion ("thd") wie zum Beispiel
Al(acac)$_3$, Cr(acac)$_3$, Zr(thd)$_2$, Mg(thd)$_2$, Cu(tfa)$_2$,
Metallalkoxyde M(OR) wie zum Beispiel
Ti(OC$_2$H$_5$)$_4$, Ti(OC$_3$H$_7$)$_4$, Ti(OC$_4$H$_{10}$ )$_4$ usw.
Entsprechende Verbindungen mit gemischten Alkoxygruppen M(OR)$_{x-n}$(OR$'$)$_n$ sowie die entsprechenden Silizium- oder Hafnium- oder Zirkoniumverbindungen.
Derivate organischer Säuren wie Al(CH$_3$COO)$_3$
Verbindungen mit verschiedenen Typen von Liganden
wie zum Beispiel die oben erwähnten Nitrosyl-Carbonyl oder Halogenid-Carbonyl Verbindungen.
Kombinationen von Carbonylgruppen mit $\pi$-Systemen zum Beispiel (C$_5$H$_5$)Ti(CO)$_3$ und entsprechende Zirkonium, Hafnium oder Siliziumverbindungen
Kombinationen von $\pi$-Systemen mit Amingruppen wie zum Beispiel (RC$_5$H$_4$)Ti(NR$_2$)$_3$ .
Kombinationen von Alkylgruppen und Alkoxygruppen zum Beispiel R$_n$Ti(OR)$_{4-n}$ und entsprechende Zirkonium, Hafnium oder Siliziumverbindungen.
Kombinationen von Alkylgruppen und Chelat-Liganden zum Beispiel (CH$_3$)$_2$Au(acac)
Kombinationen von Alkylgruppen und $\pi$-Systemen zum Beispiel (CH$_3$)$_3$Pt(C$_5$H$_5$) sowie Kombinationen mit Nitril-, Isonitril-, Phosphin, Thioäther oder Thiol Gruppen u.s.w..
Erfindungsgemäß lassen sich insbesondere folgende Oxydschichten herstellen:
SnO$_2$, GeO$_2$, Oxyde der seltenen Erden, CuO, TiO$_2$, MnO$_x$, Cr$_2$O$_3$, ZnO, PtO$_2$, Al$_2$O$_3$, BaO, SrO, ZrO$_2$, Nb$_2$O$_3$, WO$_3$, In$_2$O$_3$, NiO, Fe$_2$O$_3$, MoO$_3$, AgO, CoO, HfO$_2$, TaO$_2$, PbO, Bi$_2$O$_3$ und Sb$_2$O$_3$.
Für die erfindungsgemäß hergestellten Oxydschichten finden sich vielseitige Anwendungen von denen beispielsweise die folgenden zu nennen sind:
mechanische Schutzschichten
Hartschichten
Kratzschutzschichten
Diffusionsbarrieren
Korrosionsschutzschichten
Dekorationsschichten
optische Filter
Antireflexbelege
leitende und halbleitende Schichten
dielektrische Schichten
antistatische Belege für organische Polymere
antistatische Belege in der Mikroelektronik
Masken in der Mikroelektronik
transparente Elektroden für Solarzellen
heizbare Schichten zum Beispiel für Autofenster
haftvermittelnde Schichten
Basismaterialien für Supraleiter
HT$_c$ - Supraleiter

Im Vordergrund stehen die

mechanischen Eigenschaften, Härte, Elastizität

optischen Eigenschaften, Transparenz, Farbe, Brechungsindex

elektrischen Eigenschaften: Isolatoren, Halbleiter und Leiter.

Die folgenden Beispiele dienen zur Erläuterung der Erfindung.

BEISPIEL 1

$SnO_2$ Filme

Als Ausgangsmaterial dient Tetramethylzinn (TMT).

Apparatur: Parallelplattenreaktor, Aluminiumelektroden 13 cm 0, 3cm Abstand

Frequenz: 13.56 MHz

Art der Substrate: Glass

Vorbehandlung: 30 min Argonplasma

Temperatur des Verdampfungsgefäßes: 25° C

Gasart: $O_2$/Ar (2 : 1 bis 3 : 1)

Gasdurchsatz: 45 sccm

Druck: 50 - 133 Pa

Leistunsdichte W/cm$^2$ Elektrodenfläche: 1.5

Temperatur der Substrat tragenden Elektrode: 90° C

Abscheidungsrate: bei 50 - 80 Pa 50 A/min

Filmeigenschaften: Farblose, transpararente Filme,

bei 50 - 80 Pa Kohlenstoffgehalt unter Nachweisgrenze,

bei Gesamtdruck 133 Pa Abscheiderate 650 A/min, 2-3 % C

Maximale Leitfähigkeit = 1.1 * 10$^3$ $^{-1}$ wird erreicht bei 50 W

Gesamtdruck 47 Pa, Verhältnis $p(O_2)$ / $p(TMT)$ = 2/1.

BEISPIEL 2

$GeO_2$ - Filme

Als Ausgangsmaterial dient Tetramethylgermanium (TMG)

Apparatur: Parallelplattenreaktor, Aluminiumelektroden 13 cm 0, 3 cm Abstand

Frequenz: 13.56 MHz

Art der Substrate: Glass

Vorbehandlung: 30 min Argonplasma

Temperatur des Verdampfungsgefäßes: -50° C

Gasart: $O_2$ / Ar (2 : 1 bis 3 : 1)

Gasdurchsatz: 35 sccm

Druck: zum Beispiel 10 Pa $O_2$, 5 Pa Ar and 2.7 Pa TMG

Leistung: 70 W

Temperatur der Substrat tragenden Elektrode: 120° C Abscheidungsrate: 90 A/min

Filmeigenschaften:

Farblose, transpararente Filme, Eigenschaften und Zusammensetzung weitgehend unabhängig von den Abscheidungsparametern.

Ge Gehalt 70 + 4% ($GeO_2$ = 69.4% Ge) Dichte 3.5 - 4.5 g/cm$^3$

BEISPIEL 3

Gemischte $GeO_2$ - $SnO_2$ Filme

Als Ausgangsmaterialien dienen Tetramethylgermanium (TMG) und Tetramethylzinn (TMT)

Apparatur: Parallelplattenreaktor, Aluminiumelektroden 13 cm 0, 3 cm Abstand

Frequenz: 13.56 MHz

Art der Substrate: Glass

Vorbehandlung: 30 min Argonplasma

Temperatur des Verdampfungsgefäßes: 25 beziehungsweise -50° C

TMT und TMG werden vor dem Eintritt in die Reaktionskammere gemischt

Gasart: Ar/$O_2$ (1 : 3)

Gasdurchsatz: 40 sccm

Druck: Gesamtdruck 30 Pa, Partialdruck der organomet. Verbindungen 5 Pa

Leistung 80 W

Temperatur der Substrat tragenden Elektrode: 100

Abscheidungsrate: 50 - 100 A/min

Filmeigenschaften :

Die Filmzusammensetzung hängt ab vom Mischungsverhältnis TMG/TMT

| p(TMT) Pa | p(TMG) Pa | Sn at.% | Ge at.% | C at.% | O at.% |
|-----------|-----------|---------|---------|--------|--------|
| 4.00 | 1.33 | 26.8 | 3.2 | 3.8 | 66.2 |
| 2.67 | 2.67 | 22.1 | 6.2 | 4.6 | 67.1 |
| 1.33 | 4.00 | 10.7 | 21.3 | 0 | 68.0 |

BEISPIEL 4

Filme aus Zirkondioxid

Ausgangsmaterial: Zirkoniumhexafluoroacetylacetonat

Apparatur: Parallelplattenreaktor, Aluminiumelektroden = 30 cm Abstand 3 cm

Frequenz: 30.5 MHz

Art der Substrate: Glass, Quarz

Vorbehandlung: 10 min Argonplasma

Temperatur des Verdampfungsgefäßes: 60° C

Gasart: Sauerstoff

Gasdurchsatz: 50 sccm

Druck: 23 Pa

Leistung: 50W

Temperatur der Substrat tragenden Elektrode: 150° C

Abscheidungsrate: 12,5 nm / min Filmeigenschaften: Durchsichtige farblose, nichtleitende, amorphe, sehr harte und kratzfeste Filme

Filmanalyse 69,3 % Zr, 0,4% C (ZrO$_2$ 74%)

BEISPIEL 5

Abscheidung von ZrO$_2$ Filmen

Ausgangsmaterial Dicyclopentadienyl-dimethyl-Zirkonium Cp$_2$ZrMe$_2$

Apparatur: Parallelplattenreaktor, Alumiumelektroden 16 cm 0, 3.5 cm Abstand

Frequenz: 13.56 MHz

Art der Substrate: Glass, Quarz, Polycarbonat

Vorbehandlung: 30 min Argonplasma 100W

Temperatur des Verdampfungsgefäßes:

Gasart: Sauerstoff

Gasdurchsatz: 100 sccm

Druck: 22 Pa

Leistung: 100W

Temperatur der Substrat tragenden Elektrode: 300° C

Abscheidungsrate: 0.3 - 0.5 g/cm$^2$ min

Filmeigenschaften: Klare transparente, sehr harte Filme. Analyse 72.3 + 4% Zr (theor. für ZrO$_2$ 74.0%).

BEISPIEL 6

Abscheidung von Al$_2$ O$_3$ - Filmen

Ausgangsmaterial Trimethylaluminium

Apparatur: Parallelplattenreaktor, Aluminiumelektroden

11 cm 0, 2.5 cm Abstand Frequenz: 13.56 MHz

Art der Substrate: Glass, Al$_2$O$_3$

Vorbehandlung: 15 min Argonplasma

Temperatur des Verdampfungsgefäßes: 0° C

Gasart: Argon / Wasserstoff

Gasdurchsatz: 20 sccm

Druck: 200 mtorr (50% Argon, 40% H$_2$, 10% Alkylverbindung)

Leistung 60 Watt

Temperatur der Substrat tragenden Elektrode: 150° C

Abscheidungsrate: 40 - 60 A

Filmeigenschaften: farblose, transparente Filme

Die geringen Mengen an adsorbiertem Wasser aus der Apparatur oder aus Lecks sind ausreichend für die Oxydbildung.

BEISPIEL 7

Erzeugung von Cr$_2$O$_3$ Filmen

Ausgangsmaterial Chromhexacarbonyl Cr(CO)$_6$ Apparatur: Parallelplattenreaktor, Aluminiumelektroden 13 cm 0, 3 cm Abstand

Frequenz: 13.56 MHz

Art der Substrate: Glass, Quarz, Stahl

Vorbehandlung: keine

Temperatur des Verdampfungsgefäßes: 50° C

Gasart: Argon / Sauerstoff zu gleichen Teilen

Gasdurchsatz: 25 sccm

Druck: 20 Pa

Leistung: 100 Watt

Temperatur der Substrat-tragenden Elektrode: 100° C

Abscheidungsrate: 23 A/min

Filmeigenschaften:

Film transparent, schwach grün, 67% Cr ($Cr_2O_3$ theor. 68.4 % Cr) BEISPIEL 8

Erzeugung von amorphen $Mn_x O_y$ - Filmen

Ausgangsverbindung: Dimangandecacarbonyl $Mn_2(CO)_{10}$

Apparatur: Parallelplattenreaktor, Aluminiumelektroden

13 cm 0, 3 cm Abstand

Frequenz: 13.56 MHz

Art der Substrate:

Vorbehandlung:

Temperatur des Verdampfunmgsgefäßes: 60° C

Gasart: Argon beziehungsweise Sauerstoff

Gasdurchsatz: 30 sccm

Druck: 25 Pa

Leistung: 100 Watt

Temperatur der Substrat tragenden Elektrode: 100° C

Abscheidungsrate: 2,5 - 3,5 A/sec

Filmeigenschaften:

Mit Trägergas Argon bräunliche transparente Filme mit 71 % Mn ($Mn_2O_3$ 69,6 %, $Mn_3O_4$ 72,0 %).

Mit Trägergas Sauerstoff (35 sccm, 28 Pa) dunkelbraune Filme, deren Metallgehalt 65% beträgt, laut ESCA - Untersuchungen liegt ein Gemisch aus $MnO_2$ und $Mn_2O_3$ vor.

BEISPIEL 9

Abscheidung von $Er_2O_3$ Filmen

Als Ausgangsmaterial dient der Ertris 2,2,6,6-tetramethyl-3,5 - heptanedionato chelat Komplex

Apparatur: Parallelplattenreaktor, Aluminiumelektroden 0 = 16 cm, 3 cm Abstand

Frequenz: 13.56 MHz

Art der Substrate: Glassubstrate

Vorbehandlung: 10 min $O_2$/Ar Plasma 20 Pa, 1.5 $W/cm^2$

Temperatur des Verdampfungsgefäßes: 140° C

Gasart: Sauerstoff

Gasdurchsatz: 30 standard $cm^3$ $min^{-1}$ (sccm)

Druck: 26 Pa

Leistungsdichte $W/cm^2$ Elektrodenfläche: 1.5 $W/cm^2$

Temperatur der Substrat tragenden Elektrode: 400° C, geerdet

Abscheidungsrate: 90 - 130 nm / min

Filmeigenschaften: Farbloser Film,

85.1% Er, Kohlenstoff unter Nachweisgrenze,

$Er_2O_3$ (theor. 87.5 % Er)

BEISPIEL 10

Abscheidung von $TiO_2$ Filmen

Ausgangsmaterial Tetrabutoxytitan $Ti(O-C_4H_9)_4$

Apparatur: Parallelplattenreaktor, Aluminiumelektroden 10 cm 0, 4 cm Abstand

Frequenz: 13.56 MHz

Art der Substrate: Glass

Vorbehandlung: 10 min Argonplasma 100 W

Temperatur des Verdampfungsgefäßes: 30° C

Gasart: Sauerstoff

Gasdurchsatz: 40 sccm

Druck: 93 Pa

Leistung: 100 W
Temperatur der Substrat tragenden Elektrode: 100° C
Abscheidungsrate: 1000 A/min
Filmeigenschaften: transparente, leicht irisierende Filme

**Patentansprüche**

1. Verfahren zur Herstellung dünner Oxydschichten durch die Plasmaumsetzung metallorganischer Verbindungen, dadurch gekennzeichnet, daß flüchtige Metallverbindungen oder Mischungen aus Metallverbindungen verwendet werden.

2. Verfahren nach Anspruch 1, dadurch gekennzeichnet, daß Metallverbindungen verwendet werden, die außer den Metallatomen auch Kohlenstoff enthalten.

3. Verfahren nach Anspruch 2, dadurch gekennzeichnet, daß Metallverbindungen verwendet werden, bei denen die Metallatome entweder direkt oder über $\pi$-Bindungen oder über Heteroatome, wie Sauerstoff, Stickstoff, Schwefel oder Phosphor, mit dem Kohlenstoff verbunden sind.

4. Verfahren nach Anspruch 1, dadurch gekennzeichnet, daß die Metallverbindungen zusammen mit einem Oxydationsmittel als Reaktivgas verwendet werden.

5. Verfahren nach Anspruch 4, dadurch gekennzeichnet, daß als Oxydationsmittel Sauerstoff, Kohlendioxyd, Distickstoffoxyd oder deren Mischungen verwendet werden.

6. Verfahren nach Anspruch 4, dadurch gekennzeichnet, daß das Reaktivgas in Mischung mit einem Verdünnungsmittel, wie Helium, Argon oder Stickstoff, verwendet wird.

7. Verfahren nach Anspruch 1, gekennzeichnet durch folgende Verfahrensschritte:
- Zufügung der Metallverbindungen über Dosierventile dem Reaktor
- Beheizung des Verdampfungsgefäßes für die Metallverbindungen und der Zuleitungen zum Reaktor
- Umsetzung bei vermindertem Druck, wobei die Verbindungen dem Plasma einer elektrischen Entladung ausgesetzt werden.

8. Verfahren nach Anspruch 7, dadurch gekennzeichnet, daß für die Umsetzung eine Glimmentladung verwendet wird.

9. Verfahren nach Anspruch 8, dadurch gekennzeichnet, daß die Glimmentladung in Parallelplattenreaktoren, Barrelreaktoren oder anderen Anlagen erzeugt wird.

10. Verfahren nach Anspruch 9, dadurch gekennzeichnet, daß die Glimmentladung mit Gleichspannung oder nieder- oder hochfrequenter Wechselspannung betrieben wird.

11. Verfahren nach Anspruch 9, dadurch gekennzeichnet, daß an die Elektroden der Parallelplattenreaktoren eine Zusatzspannung angelegt wird.

12. Verfahren nach Anspruch 9, dadurch gekennzeichnet, daß die Elektroden, auf denen die zu beschichtenden Substrate liegen, sowie andere Substratträger thermostatisiert werden.

13. Dünne Oxydschichten hergestellt nach Verfahren gemäß Ansprüchen 1 bis 12 insbesondere zur Herstellung von $SnO_2$, $GeO_2$, $TiO_2$, $MnO_x$, $Cr_2O_3$, $ZnO$, $PtO_2$, $Al_2O_3$, $BaO$, $SrO$, $ZrO_2$, $Nb_2O_3$, $WO_3$, $In_2O_3$, $NiO$, $Fe_2O_3$, $MoO_3$, $AgO$, $CoO$, $HfO_2$, $TaO_2$, $Pbo$, $Bi_2O_3$ oder $Sb_2O_3$.

14. Verwendung der dünnen Oxydschichten gemäß Anspruch 13 zur Herstellung von Schutzschichten, Leitungen, halbleitenden Schichten oder dielektrischen Schichten oder antistatischen Belegen:

Europäisches
Patentamt

**EUROPÄISCHER**
**RECHERCHENBERICHT**

Nummer der Anmeldung

**EP 90 11 0659**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | JAPANESE JOURNAL OF APPLIED PHYSICS, Band 28, Nr. 7, July 1989, Teil 2, Seiten L1096-L1097, Tokyo, JP; T. MARUYAMA et al.: "Plasma metalorganic chemical vapor deposition of indium oxide thin films" * Insgesamt * | 1-5,7-10, 13,14 | C 23 C 16/40 |
| X | J. VACUUM SCIENCE & TECHNOLOGY/PART A, Band 13, Nr. 5, September/Oktober 1986, Seiten 2377-2383, Woodbury, US; C.E. TRACY et al.: "Preparation of amorphous electrochromic tungsten oxide and molybdenum oxide by plasma enhanced chemical vapor deposition" * Insgesamt * | 1-10,13, 14 | |
| X | THIN SOLID FILMS, Band 96, Nr. 2, Oktober 1982, Seiten 149-154, Lausanne, CH; M. SHIMIZU et al.: "Preparation of ZnO thin films by plasma-enhanced organometallic chemical vapour deposition" * Insgesamt * | 1-10,13, 14 | |
| X | US-A-4 675 089  (E.R. LORY et al.) * Spalte 2, Zeile 40 - Spalte 3, Zeile 56; Zusammenfassung * | 1-5,7-10, 13,14 | RECHERCHIERTE SACHGEBIETE (Int. Cl.5) |
| X | PATENT ABSTRACTS OF JAPAN, Band 8, Nr. 46 (C-212)[1483], 29. Februar 1984; & JP-A-58 204 171 (TOKYO SHIBAURA DENKI K.K.) 28-11-1983 * Insgesamt * | 1-5,7-10, 13,14 | C 23 C |
| X | US-A-4 140 814  (J. HYNECEK) * Insgesamt * | 1-5,7-10, 13,14 | |

−/−

Der vorliegende Recherchenbericht wurde für alle Patentansprüche erstellt

| Recherchenort | Abschlußdatum der Recherche | Prüfer |
|---|---|---|
| Den Haag | 10 Januar 91 | JOFFREAU P.O. |

**Europäisches
Patentamt**

# EUROPÄISCHER
# RECHERCHENBERICHT

Nummer der Anmeldung

## EP 90 11 0659

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 265 246   (MATSUSHITA ELECTRIC INDUSTRIAL CO., LTD)<br>* Zusammenfassung; Seite 5, Zeile 50 - Seite 6, Zeile 9; Seite 11, Zeilen 1-25 *<br>– – – | 1-10,13, 14 | |
| X | EP-A-0 342 009   (OKI ELECTRIC INDUSTRY CO., LTD)<br>* Seite 3, Zeile 54 - Seite 8, Zeile 55 *<br>– – – – – | 1-10,13, 14 | |
| | | | **RECHERCHIERTE SACHGEBIETE (Int. Cl.5)** |
| Der vorliegende Recherchenbericht wurde für alle Patentansprüche erstellt | | | |

| Recherchenort | Abschlußdatum der Recherche | Prüfer |
|---|---|---|
| Den Haag | 10 Januar 91 | JOFFREAU P.O. |

KATEGORIE DER GENANNTEN DOKUMENTE
X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
    nach dem Anmeldedatum veröffentlicht worden ist
D : in der Anmeldung angeführtes Dokument
L : aus anderen Gründen angeführtes Dokument
------------------------------------------------------------
& : Mitglied der gleichen Patentfamilie,
    übereinstimmendes Dokument